# EUROPEAN PATENT APPLICATION

(11) **EP 0 582 294 A2**
(43) Date of publication of application: **09.02.1994**
(21) Application number: 93112518.1
(22) Date of filing: 04.08.1993
(51) Int. Cl.: G11C 11/411

(54) **Memory device**

(30) Priority: 05.08.1992 JP 229260/92
(71) Applicant: YOZAN INC., Tokyo 155 (JP); SHARP KABUSHIKI KAISHA, Osaka 545 (JP)
(72) Inventor: Shou, Guoliang, c/o YOZAN Inc., Tokyo 155 (JP); Yamamoto, Makoto, c/o YOZAN Inc., Tokyo 155 (JP); Takatori, Sunao, c/o YOZAN Inc., Tokyo 155 (JP)
(74) Representative: Grünecker, Kinkeldey, Stockmair & Schwanhäusser Anwaltssozietät

(57) **Abstract**

The present invention has an object to provide a memory device without the necessity of refreshment, whose circuit is small size.

A memory device structuring a memory cell by connecting the follows: i) the first transistor of NPN type, having connection of input voltage to its base and grounding an emitter; ii) the second transistor of PNP type having connection of base to a collector of the first transistor, grounding collector and connection of power source to an emitter; and iii) the collector of the second transistor to the base of the first transistor.

## Description

### FIELD OF THE INVENTION

The present invention relates to a memory device, especially to that without the necessity of refreshment.

### BACKGROUND OF THE INVENTION

Conventionally, static RAM generally constructs a memory cell by a flip-flop There are problems that the size of the circuit is rather large, the memory capacity is small and it is expensive to make it using flip-flop.

### SUMMARY OF THE INVENTION

The present invention solves the above-mentioned problems of the prior art and has an object to provide a memory device without the necessity of refreshment, whose circuit is small size. A memory device of this invention constructs a self-holding circuit by a couple of transistors.

### BRIEF DESCRIPTION OF THE DRAWINGS

Figure 1 shows a circuit of the first embodiment of this invention.

Figure 2 shows a circuit of the second embodiment of this invention.

### PREFERRED EMBODIMENT OF THE PRESENT INVENTION

Hereinafter, the present invention is described with reference to the attached drawings.

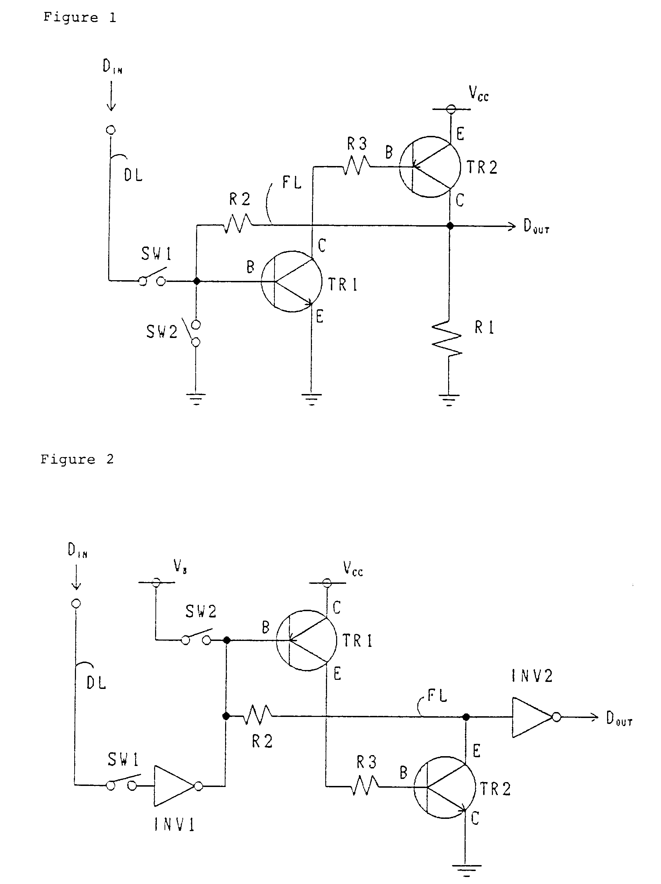

Figure 1 shows one memory cell of a memory device. It constructs a self-holding circuit by the first transistor TR1 of PNP type and the second transistor TR2 of the NPN type.

The base of transistor TR1 is connected to data line DL through switch SW1 which is opened and closed by an address control (not shown). When data "Din" is high level, switch SW1 is closed, then, the gate voltage of transistor TR1 is high level and the transistor TR1 is conductive. Collector "C" and emitter "E" of transistor TR1 is connected to the base of the second transistor TR2, and is grounded, respectively. Therefore, when transistor TR1 is conductive, the base of transistor TR2 is low level and transistor TR2 is conductive. Emitter "E" and collector "C" of transistor TR2 is connected to power source "Vcc" and is grounded, respectively. The electric voltage of the collector "C" rises under conduction.

The collector "C" is connected to the base "B" of transistor TR1 through conductor "FL". Even when switch SW1 is opened after transistor TR1 is once conductive, transistor TR1 keeps conductive by electric voltage of collector "C". That is, the circuit in Figure 1 constructs a self-holding circuit. The electric voltage of collector "C" is output as output data "Dout". The collector "C" of transistor TR'' is grounded through high resistance "R1", which keeps the level of "Dout".

Grounded reset switch SW2 is connected to the base of transistor TR1 in order to reset the memory cell once in high level back into low level. When reset switch SW2 is closed, the base of transistor TR1 is grounded and transistor TR1 is cut off. Protect resistance R2 is set on the conductor FL so as to prevent transistor TR2 from being passed large quantity of electric current when reset switch SW2 is closed. Protecting resistance R3 is set between collector "C" of transistor TR1 and base "B" of transistor TR2 so as to protect transistor TR1 in a conductive state of transistor TR1.

In this way, it is possible to construct a memory cell without the necessity of refreshment and to realize a memory device with a small-sized circuit by a couple to transistors.

Figure 2 shows the circuit of the second embodiment of this invention. The same parts as and the parts corresponding to the circuit in Figure 1 are given the same alphabetical symbols as in Figure 1. In this embodiment, the first transistor is NPN type and the second transistor is PNP type. Data "Din" is input to transistor TR1 through inverter "INV1" and transistor "TR1" is reset by reset switch SW2 connected to power source "V_{B}". In the same way of Figure 1, protective resistance R3 is connected between emitter "E" of transistor "TR1" and base "B" of transistor "TR2".

Collector "C" and emitter "E" of transistor "TR1" are connected to power source "V_{CC}" and the base of transistor "TR2", respectively. When high level data Din is input to inverter INV1 through switch SW1, low level of electric voltage is impressed on the base of transistor TR1 and transistor TR1 is conductive. Then, high level of electric voltage of power source V_{CC} is impressed on the base of transistor TR2 and transistor TR2 is conductive. The collector of transistor TR2 is grounded: when it is conductive, emitter "E" is low level.

The emitter "E" is connected to the base "B" of transistor TR1 through conductor "FL", and the electric voltage of the base of TR1 is kept low level under conduction of transistor TR2. Therefore, the state of transistors TR1 and TR2 is maintained by themselves. Inverter INV2 is connected to the emitter E of transistor TR2. The output of inverter INV2 is the output data of Dout. Protective resistance "R2" is set on conductive FL, which arrests large quantity of electric currency on transistor TR2 from power source V_{B} on resetting.

It is possible to realize a memory device without the necessity of refreshment by a small size of circuit also by such construction as above.

As mentioned, since a memory device of this invention constructs a self-holding circuit by a couple of transistors, it is not necessary to refresh and the size of it is small.

## Claims

1. A memory device having a memory cell comprising:
i) the first transistor of PNP type, having connection of input voltage to its base and grounding an emitter;
ii) the second transistor of NPN type having connection of base to a collector of said first transistor, grounding collector and connection of power source to an emitter; and
iii) said collector of said second transistor to said base of said fist transistor.

2. A memory device claimed in claim 1, further connecting a protect resistance to a conductor leading from the second collector to said base of the first transistor.

3. A memory device having a memory cell comprising:
i) the first transistor of NPN type connected inverse output of input voltage to a base thereof; and
ii) the second transistor having connection of base to an emitter of said first transistor, grounding collector and connection of said emitter to said base of said first transistor.

4. A memory device claimed in claim 3, further connecting protect resistance to a conductor leading from an emitter of said first transistor to said base of said first transistor.
